(19) Europäisches Patentamt / European Patent Office / Office européen des brevets

(11) **EP 2 623 576 A1**

(12) **EUROPÄISCHE PATENTANMELDUNG**


(43) Date of publication:
**07.08.2013 Bulletin 2013/32**

(51) Int Cl.:
***C09J 183/06*** *(2006.01)*

(21) Application number: **13151595.9**

(22) Date of filing: **17.01.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **03.02.2012 JP 2012022266**



(71) Applicant: **Shin-Etsu Chemical Co., Ltd.**
**Tokyo (JP)**

(72) Inventors:
- **Kashiwagi, Tsutomu**
  **Annaka-shi, Gunma (JP)**
- **Shiobara, Toshio**
  **Tokyo, Tokyo (JP)**

(74) Representative: **von Füner, Nicolai et al**
**Von Füner Ebbinghaus Finck Hano**
**Patentanwälte**
**Mariahilfplatz 3**
**81541 München (DE)**


(54) **Adhesive silicone composition sheet containing phosphorus and method of producing light emitting device using the same**


(57) An adhesive silicone composition sheet, in which a phosphor is dispersed uniformly and in which the dispersion state of the phosphor is stable over time, which is a solid or semisolid in an uncured state at room temperature and is therefore easy to handle, and which can easily form a silicone resin layer on the surface of an LED chip using conventional assembly apparatus. The adhesive silicone composition sheet is formed from a heat-curable silicone resin composition, which comprises: (1) an organopolysiloxane in which at least 90% of the organic groups bonded to silicon atoms are methyl groups, (2) a curing agent, and (3) a phosphor, and which exists in a plastic solid or semisolid state at normal temperature.


Fig. 1

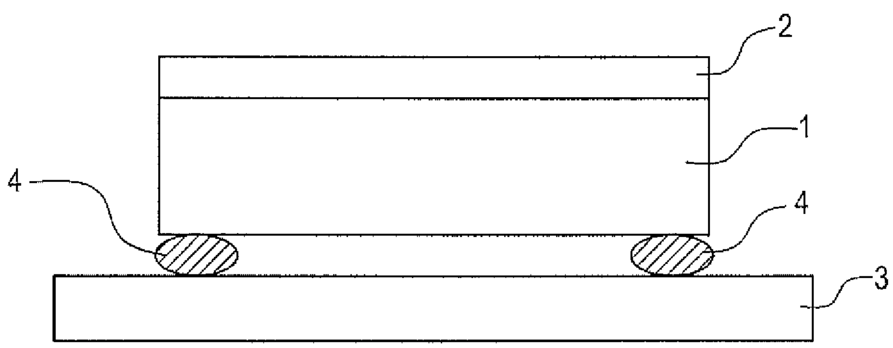


EP 2 623 576 A1

**Description**

BACKGROUND OF THE INVENTION

1. Field of the Invention

The present invention relates to a condensation curable phosphor-containing adhesive silicone composition sheet, which when laminated and bonded to the chip surface of an LED element converts the wavelength of a blue light or ultraviolet light from the LED, and which exists as a solid or semisolid at room temperature in an uncured state (namely, prior to heat treatment), and also relates to a sheet-like cured product obtained by heat-curing the silicone composition sheet, a method of producing a light emitting device using the silicone composition sheet, and a light emitting device.

2. Description of the Prior Art

In the field of light emitting diodes (LED), the use of phosphors for the purpose of wavelength conversion is already known (Patent Document 1). On the other hand, silicone resins exhibit excellent light resistance properties, and are therefore attracting much attention as coating materials for encapsulating and protecting LED elements (Patent Document 2).

Generally, in a white LED, a phosphor is dispersed in the vicinity of the LED chip by using a method in which the chip is coated with a silicone resin or epoxy resin containing the dispersed phosphor, thereby converting the blue light to a pseudo white light.

However, if the dispersion of the phosphor within the resin layer lacks uniformity or is biased, then a color shift is likely to occur, and therefore in order to produce a uniform white light, it is necessary to ensure that the phosphor is dispersed uniformly within the coating resin layer. As a result, screen printing methods and methods that involve dispersing the phosphor by precipitation have been investigated, but these methods have suffered from various problems, including a complex production process and an unsatisfactory level of stability. Accordingly, a simple technique of dispersing a phosphor uniformly across a chip surface has been keenly sought.

Further, in LEDs and the like, the resin layer covering the LED element also requires high levels of heat resistance and ultraviolet resistance and the like. It would also be industrially advantageous if such resin layers could be formed using conventional production apparatus.

Patent Document 1: JP 2005-524737 A
Patent Document 2: JP 2004-339482 A

SUMMARY OF THE INVENTION

Accordingly, an object of the present invention is to provide an adhesive silicone composition sheet, in which a phosphor is dispersed uniformly and in which the dispersion state of the phosphor is stable over time, which is a solid or semisolid in an uncured state at room temperature and is therefore easy to handle, and which can easily form a silicone resin layer on the surface of an LED chip using a conventional assembly apparatus.

As a result of intensive research aimed at achieving the above object, a first aspect of the present invention provides an adhesive silicone composition sheet formed from a heat-curable silicone resin composition, which comprises:

(1) an organopolysiloxane in which at least 90% of the organic groups bonded to silicon atoms are methyl groups,
(2) a curing agent, and
(3) a phosphor,

and which exists in a plastic solid or semisolid state at normal temperature.

Representative embodiments of the above composition sheet include the following.

- The composition sheet described above, wherein:

the organopolysiloxane of the component (1) is an organopolysiloxane having a polystyrene-equivalent weight-average molecular weight maximum value of at least $1\times10^4$, represented by an average composition formula (1) shown below:

$$R^1_a(OX)_bSiO_{(4-a-b)/2} \qquad (1)$$

wherein each $R^1$ independently represents an alkyl group, alkenyl group or aryl group of 1 to 6 carbon atoms, each X independently represents $-Si(R^2R^3R^4)$ (wherein each of $R^2$, $R^3$ and $R^4$ represents an alkyl group, alkenyl group, aryl group, or halogen-substituted group thereof, provided that at least 90% of the combination of all $R^1$, $R^2$, $R^3$ and $R^4$ groups within the formula are methyl groups), or an alkyl group, alkenyl group, alkoxyalkyl group or acyl group of 1 to 6 carbon atoms, a represents a number from 1.00 to 1.50 and b represents a number that satisfies $0<b<2$, provided that a+b satisfies $1.00<a+b<2.00$, and
the curing agent of the component (2) is a condensation catalyst.

- The composition sheet described above, wherein $R^2$, $R^3$ and $R^4$ are methyl groups.
- The composition sheet described above, wherein $R^1$ is an alkyl group of 1 to 6 carbon atoms.
- The composition sheet described above, wherein $R^1$ is a methyl group.

- The composition sheet described above, wherein the condensation catalyst of the component (2) is an organometallic catalyst.
- The composition sheet described above, wherein the organometallic catalyst comprises at least one type of atom selected from the group consisting of tin, zinc, aluminum and titanium.
- The composition sheet described above, wherein the organometallic catalyst is an aluminum chelate compound.
- The composition sheet described above, wherein organometallic catalyst is an acetylacetone-modified aluminum compound.

- The composition sheet described above, wherein the composition further comprises an organic solvent, and the composition sheet is obtained by applying the composition to a substrate to form a coating, and then drying the coating by heating.
- The composition sheet described above, comprising 0.05 to 10 parts by mass of the condensation catalyst of the component (2) and 0.1 to 1,000 parts by mass of the phosphor of the component (3) per 100 parts by mass of the organopolysiloxane of the component (1).
- The composition sheet described above, wherein the average particle diameter of the phosphor of the component (3) is from 1 to 50 $\mu$m.

A second aspect of the present invention provides a method of producing a light emitting device having a covered LED element, the method comprising: disposing the above adhesive silicone composition sheet on the surface of the LED element, and curing the composition sheet by heating, thereby covering the surface of the LED element with a phosphor-containing cured silicone resin layer.
A third aspect of the present invention provides a light emitting device having a covered LED element, which is obtained using the production method described above.
The composition sheet of the present invention has favorable handling properties and can easily form a cured phosphor-containing layer that covers an LED element, and the thus formed cured product layer exhibits excellent heat resistance, ultraviolet resistance, optical transparency, toughness and adhesiveness, and also has a small refractive index. Accordingly, the composition sheet is particularly useful for encapsulating LED elements.

BRIEF DESCRIPTION OF THE DRAWINGS

FIG. 1 is a schematic diagram illustrating the structure of a light emitting semiconductor (LED) device having a flip-chip structure, prepared for the purpose of measuring brightness in the examples.

EMBODIMENTS OF THE INVENTION

The present invention is described below in detail. In the present description, room temperature refers to a temperature of 24$\pm$2°C (namely, 22 to 26°C).

<Composition Sheet>

The adhesive silicone composition sheet of the present invention is formed from a heat-curable silicone resin composition, which comprises:

(1) an organopolysiloxane in which at least 90% of the organic groups bonded to silicon atoms are methyl groups,
(2) a curing agent, and
(3) a phosphor,

and which exists in a plastic solid or semisolid state at normal temperature.

In the present invention, examples of preferred organic groups include hydrocarbon groups, and alkyl groups, alkenyl groups and aryl groups of 1 to 6 carbon atoms are particularly preferred. One or more of the hydrogen atoms of the hydrocarbon group may each be substituted with a halogen atom.
In the organopolysiloxane of the component (1), which represents the main component of the composition that constitutes the composition sheet of the present invention, at least 90%, preferably at least 92%, and more preferably at least 94%, of the organic groups bonded to silicon atoms within the organopolysiloxane are methyl groups. This yields superior heat resistance, and discoloration resistance.

Depending on the type of curing reaction employed, a condensation catalyst or a combination of an organohydrogensiloxane and a hydrosilylation catalyst or the like can be used as the curing agent of the component (2). The organopolysiloxane of the component (1) may be selected appropriately by a person skilled in the art in accordance with the nature of the curing agent of the component (2). In other words, when a condensation catalyst is used as the component (2), an organopolysiloxane having condensable hydroxyl groups or groups that undergo hydrolysis-condensation is selected as the component (1). On the other hand, when a combination of an organohydrogensiloxane and a hydrosilylation catalyst is used as the component (2), an organopolysiloxane having alkenyl groups is selected as the component (A1).

The above composition preferably comprises 0.05 to 10 parts by mass of the curing agent of the component (2) and 0.1 to 1,000 parts by mass of the phosphor of the component (3) per 100 parts by mass of the organopolysiloxane of the component (1).

The phosphor of the component (3) is described in detail below in relation to a component (C) in a preferred embodiment.

The composition sheet of the present invention is formed from a heat-curable resin composition which exists in a plastic solid or semisolid state in an uncured state at normal temperature. Here, the expression "normal temperature" means the ambient temperature under typical conditions, and usually refers to a temperature within a range from 15 to 30°C, and typically 25°C. The term "semisolid" describes the state of a material which has plasticity, and which when molded into a specific shape, is able to retain that shape for at least one hour, and preferably 8 hours or longer. For example, although a fluid material that has an extremely high viscosity at normal temperature does essentially exhibit fluidity, in those cases when the extremely high viscosity means that no visual change (such as collapse) in an imparted shape can be ascertained during a short period of at least one hour, the material is deemed to exist in a semisolid state.

<Preferred Embodiment>

One example of a particularly preferred embodiment of the composition sheet of the present invention is a composition sheet formed from a composition comprising:

(A) an organopolysiloxane having a polystyrene-equivalent weight-average molecular weight maximum value of at least $1\times10^4$, represented by an average composition formula (1) shown below:

$$R^1_a(OX)_bSiO_{(4-a-b)/2} \qquad (1)$$

wherein each $R^1$ independently represents an alkyl group, alkenyl group or aryl group of 1 to 6 carbon atoms, each X independently represents $-Si(R^2R^3R^4)$ (wherein each of $R^2$, $R^3$ and $R^4$ represents an alkyl group, alkenyl group, aryl group, or halogen-substituted group thereof, provided that at least 90% of the combination of all $R^1$, $R^2$, $R^3$ and $R^4$ groups within the formula are methyl groups), or an alkyl group, alkenyl group, alkoxyalkyl group or acyl group of 1 to 6 carbon atoms, a represents a number from 1.00 to 1.50 and b represents a number that satisfies $0<b<2$, provided that a+b satisfies $1.00<a+b<2.00$,
(B) a condensation catalyst as the curing agent, and
(C) a phosphor.

This preferred composition is described below in detail.

[(A) Organopolysiloxane]

The component (A) is an organopolysiloxane having a polystyrene-equivalent weight-average molecular weight maximum value of at least $1\times10^4$, represented by the average composition formula (1) shown below:

$$R^1_a(OX)_bSiO_{(4-a-b)/2} \qquad (1)$$

wherein each $R^1$ independently represents an alkyl group, alkenyl group or aryl group of 1 to 6 carbon atoms, each X independently represents $-Si(R^2R^3R^4)$ (wherein each of $R^2$, $R^3$ and $R^4$ represents an alkyl group, alkenyl group, aryl group, or halogen-substituted group thereof, provided that at least 90% of the combination of all $R^1$, $R^2$, $R^3$ and $R^4$ groups within the formula are methyl groups), or an alkyl group, alkenyl group, alkoxyalkyl group or acyl group of 1 to 6 carbon atoms, a represents a number from 1.00 to 1.50 and b represents a number that satisfies $0<b<2$, provided that a+b satisfies $1.00<a+b<2.00$.

In the above formula (1), examples of the alkyl group represented by $R^1$ include a methyl group, ethyl group, propyl group and butyl group. An example of the alkenyl group is a vinyl group. An example of the aryl group is a phenyl group. Among these, $R^1$ is preferably a methyl group. Examples of the halogen-substituted group include a trichloromethyl group, trifluoropropyl group and 3,3,4,4,5,5,6,6,6-nonafluorohexyl group.

In the formula (1), the group $-Si(R^2R^3R^4)$ represented by X is, as described below, a group obtained by silylating a hydroxyl group within a hydrolyzed organopolysiloxane, wherein $R^2$, $R^3$ and $R^4$ of the silyl group are unreactive substituted or unsubstituted monovalent hydrocarbon groups, examples of which include alkyl groups such as a methyl group, ethyl group and propyl group, alkenyl groups such as a vinyl group, aryl groups such as a phenyl group, and halogen-substituted organic groups thereof. Specific examples of the halogen-substituted groups include a trichloromethyl group, trifluoropropyl group and 3,3,4,4,5,5,6,6,6-nonafluorohexyl group.

Further, in formula (1), examples of the alkyl group represented by X include a methyl group, ethyl group, propyl group, isopropyl group, butyl group and isobutyl group. An example of the alkenyl group is a vinyl group. Examples of the alkoxyalkyl group include a methoxyethyl group, ethoxyethyl group and butoxyethyl group. Examples of the acyl group include an acetyl group and propionyl group.

In formula (1), a is preferably a number from 1.00 to 1.50, and b is a number that satisfies $0<b<2$, preferably satisfies $0.01\leq b\leq1.0$, and more preferably satisfies $0.05\leq b\leq0.3$. When a is less than 1.00, the coating obtained upon curing the resulting composition sheet is prone to cracking, whereas when a exceeds 1.50, the toughness of the coating deteriorates, and the coating tends to become brittle. When b is 0, the adhesiveness to substrates is poor, whereas when b is 2 or greater, a cured coating may sometimes be unobtainable. Further the value of a+b preferably satisfies $1.00\leq a+b\leq1.50$, and more preferably satisfies $1.10\leq a+b\leq1.30$.

The organopolysiloxane of this component can be obtained:

by hydrolysis and condensation of a silane compound represented by general formula (2) shown below:

$$SiR^5_c(OR^6)_{4-c} \qquad (2)$$

wherein each $R^5$ independently represents a group as defined above for $R^1$, each $R^6$ independently represents a group as defined above for X with the exception of groups represented by $-SiR^2R^3R^4$, and c represents an integer of 1 to 3, or

by cohydrolysis and condensation of a silane compound represented by formula (2) and an alkyl silicate represented by general formula (3) below:

$$Si(OR^6)_4 \qquad (3)$$

wherein each $R^6$ independently represents a group as defined above, and/or a condensation polymerization product of such an alkyl silicate (namely, an alkyl polysilicate) (hereafter the generic term "alkyl (poly)silicate" may be used to jointly describe an alkyl silicate and an alkyl polysilicate). These silane compounds and alkyl (poly)silicates may be used individually, or in combinations of two or more different compounds.

Examples of the silane compound represented by the above formula (2) include methyltrimethoxysilane, methyltriethoxysilane, ethyltrimethoxysilane, ethyltriethoxysilane, phenyltrimethoxysilane, phenyltriethoxysilane, dimethyldimethoxysilane, dimethyldiethoxysilane, diphenyldimethoxysilane, diphenyldiethoxysilane, methylphenyldimethoxysilane and methylphenyldiethoxysilane, and among these, methyltrimethoxysilane and dimethyldimethoxysilane are preferred. These silane compounds may be used individually, or in combinations of two or more different compounds.

Examples of the alkyl silicate represented by the above formula (3) include tetraalkoxysilanes such as tetramethoxysilane, tetraethoxysilane and tetraisopropyloxysilane, whereas examples of the condensation polymerization product of such an alkyl silicate (namely, an alkyl polysilicate) include methyl polysilicate and ethyl polysilicate. These alkyl (poly)silicates may be used individually, or in combinations of two or more different compounds.

Among the above possibilities, in order to ensure that the obtained cured product has particularly superior levels of crack resistance and heat resistance, the organopolysiloxane of this component is preferably formed from 50 to 100 mol% of an alkyltrialkoxysilane such as methyltrimethoxysilane and from 50 to 0 mol% of a dialkyldialkoxysilane such as dimethyldimethoxysilane, and is even more preferably formed from 75 to 85 mol% of an alkyltrialkoxysilane such as methyltrimethoxysilane and from 25 to 15 mol% of a dialkyldialkoxysilane such as dimethyldimethoxysilane.

In a preferred embodiment of the present invention, the organopolysiloxane of this component can be obtained by subjecting a silane compound represented by the above formula (2) to a two-stage hydrolysis and condensation reaction that includes a primary hydrolysis and a secondary hydrolysis, or by subjecting the silane compound and an alkyl (poly)silicate to a two-stage hydrolysis and condensation reaction that includes a primary hydrolysis and a secondary hydrolysis. For example, the conditions described below can be used.

The silane compound represented by formula (2) and the alkyl (poly)silicate are typically dissolved in an organic solvent such as an alcohol, ketone, ester, cellosolve or aromatic compound prior to use. Specific examples of preferred organic solvents include alcohols such as methanol, ethanol, isopropyl alcohol, isobutyl alcohol, n-butanol and 2-butanol, and in terms of achieving superior curability for the resulting composition and excellent toughness for the obtained cured product, isobutyl alcohol is particularly desirable.

Moreover, the hydrolysis and condensation of the silane compound represented by formula (2) and the alkyl (poly)silicate is preferably performed using an acid catalyst such as acetic acid, hydrochloric acid or sulfuric acid as a primary hydrolysis catalyst. The amount of water added during the primary hydrolysis and condensation is typically within a range from 0.9 to 1.5 mol, and preferably from 1.0 to 1.2 mol, per 1 mol of the combined total of all the alkoxy groups within the silane compound or the combination of the silane compound and the alkyl (poly)silicate. When the amount of water satisfies this range from 0.9 to 1.5 mol, the resulting composition exhibits excellent workability, and the cured product of the composition exhibits excellent toughness.

The polystyrene-equivalent weight-average molecular weight maximum value of the organopolysiloxane that represents the product of the primary hydrolysis and condensation is preferably within a range from $5\times10^3$ to $6\times10^4$, and more preferably from $1\times10^4$ to $4\times10^4$.

Here, the weight-average molecular weight refers to the weight-average molecular weight measured by gel permeation chromatography (GPC) under the conditions listed below, using polystyrenes as standard reference materials.

[Measurement conditions]

- Developing solvent: THF
- Flow rate: 0.6 mL/min.
- Detector: differential refractive index detector (RI)
- Columns: TSK Guard column Super H-L
  TSKgel Super H4000 (6.0 mm I.D. × 15 cm × 1)
  TSKgel Super H3000 (6.0 mm I.D. × 15 cm × 1)
  TSKgel Super H2000 (6.0 mm I.D. × 15 cm × 2)
  (all manufactured by Tosoh Corporation)
- Column temperature: 40°C
- Sample injection volume: 20 μL (THF solution having a concentration of 0.5% by weight)

The secondary hydrolysis and condensation reaction uses a secondary hydrolysis and condensation catalyst to produce a higher molecular weight organopolysiloxane from the organopolysiloxane obtained in the primary hydrolysis and condensation reaction.

A polystyrene-based anion exchange resin is used as the secondary hydrolysis and condensation catalyst. Examples of polystyrene-based anion exchange resins that can be used favorably include the Diaion series of products (manufactured by Mitsubishi Chemical Corporation). Specific examples of these products include the Diaion SA series (SA10A, SA11A, SA12A, NSA100, SA20A and SA21A), the Diaion PA series (PA308, PA312, PA316, PA406, PA412 and PA418), the Diaion HPA series (HPA25), and the Diaion WA series (WA10, WA20, WA21J and WA30).

Of the above anion exchange resins, SA10A represented by structural formula (4) shown below can be used

particularly favorably. SA10A is a moisture-containing polystyrene-based anion exchange resin, wherein the moisture within SA10A causes the reaction to proceed under the catalytic effect of the basic ion exchange resin of SA10A.

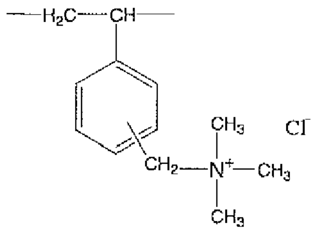

(4)

The amount of this secondary hydrolysis catalyst is typically from 1% by mass to 50% by mass, and preferably from 5% by mass to 30% by mass, relative to the non-volatile fraction of the organopolysiloxane obtained as the primary hydrolysis product (following drying at 150°C for one hour). If the amount is less than 1% by mass, then the reaction that yields the increase in the molecular weight of the organopolysiloxane proceeds slowly, whereas if the amount exceeds 50% by mass, gelling tends to become more likely. The secondary hydrolysis catalyst may employ a single catalyst, or a combination of two or more catalysts.

The temperature for this secondary hydrolysis reaction is preferably from 0°C to 40°C, and more preferably from 15°C to 30°C, as such temperatures allow the reaction to proceed favorably. If reaction temperature is less than 0°C, then the reaction is slow, whereas if the temperature exceeds 40°C, gelling becomes more likely.

Furthermore, this secondary hydrolysis reaction is preferably conducted within a solvent, and the reaction is preferably conducted at a solid fraction concentration of 50% by mass to 95% by mass, and more preferably from 65% by mass to 90% by mass. If the solid fraction concentration is less than 50% by mass, then the reaction proceeds slowly, whereas if the solid fraction concentration exceeds 95% by mass or the reaction is performed without using a solvent, then the reaction proceeds rapidly, and gelling is more likely to occur.

Although there are no particular limitations on the solvent used in the secondary hydrolysis, a solvent with a boiling point of 64°C or higher is preferred. Specific examples of such solvents include hydrocarbon-based solvents such as benzene, toluene and xylene, ether-based solvents such as tetrahydrofuran and 1,4-dioxane, ketone-based solvents such as methyl ethyl ketone, halogenated hydrocarbon-based solvents such as 1,2-dichloroethane, alcohol-based solvents such as methanol, ethanol, isopropyl alcohol and isobutyl alcohol, as well as octamethylcyclotetrasiloxane and hexamethyldisiloxane. Organic solvents with boiling points of 150°C or higher can also be used, including cellosolve acetate, cyclohexanone, butyrocellosolve, methyl carbitol, carbitol, butyl carbitol, diethyl carbitol, cyclohexanol, diglyme and triglyme. These organic solvents may be used individually, or in combinations of two or more different solvents. For the solvent, xylene, isobutyl alcohol, diglyme and triglyme are preferred, and isobutyl alcohol is particularly desirable.

The polystyrene-equivalent weight-average molecular weight maximum value of the organopolysiloxane that represents the product of the secondary hydrolysis and condensation is preferably at least $1\times10^4$, and is more preferably within a range from $3\times10^4$ to $4\times10^5$. If the weight-average molecular weight maximum value is less than $1\times10^4$, then the cured coating tends to be prone to cracking, and obtaining a coating with a thickness of at least 50 μm becomes difficult.

The high molecular weight organopolysiloxane obtained from this secondary hydrolysis has a high molecular weight, and is consequently prone to gelling via condensation of the residual hydroxyl groups. This gelling problem can be resolved by silylating the residual hydroxyl groups to obtain a stable high molecular weight organopolysiloxane.

Examples of methods of silylating the residual hydroxyl groups within the organopolysiloxane with silyl groups have unreactive substituents include a method that comprises reaction with a trialkylhalosilane, a method that uses a nitrogen-containing silylation agent such as a hexaalkyldisilazane, N,N-diethylaminotrialkylsilane, N-(trialkylsilyl)acetamide, N-methyl(trialkylsilyl)acetamide, N,O-bis(trialkylsilyl)acetamide, N,O-bis(trialkylsilyl)carbamate or N-trialkylsilylimidazole, a method that comprises reaction with a trialkylsilanol, and a method that comprises reaction with a hexaalkyldisiloxane in the presence of a weak acid. In those cases where a trialkylhalosilane is used, a base may also be added to neutralize the hydrogen halide that is generated as a by-product. In those cases where a nitrogen-containing silylation agent is used, a catalyst such as trimethylchlorosilane or ammonium sulfate may also be added. Specifically, a method that uses trimethylchlorosilane as the silylation agent in the presence of triethylamine is particularly favorable. The silylation reaction may be either conducted within a solvent, or conducted without using a solvent. Examples of suitable solvents include aromatic hydrocarbon solvents such as benzene, toluene and xylene, aliphatic hydrocarbon solvents such as hexane and heptane, ether-based solvents such as diethyl ether and tetrahydrofuran, ketone-based solvents such as acetone and methyl ethyl ketone, ester-based solvents such as ethyl acetate and butyl acetate, halogenated hydrocarbon solvents such as chloroform, trichloroethylene and carbon tetrachloride, as well as dimethylformamide and dimethylsulfoxide. The reaction temperature for this type of silylation reaction is typically from 0°C to 150°C, and is

preferably from 0°C to 60°C.

Because a high molecular weight organopolysiloxane of the component (A) obtained using the production method described above is used, the resulting cured coating exhibits a high level of strength, displays favorable flexibility and adhesion, and has superior properties that enable the formation of a thick sheet having a thickness of 50 μm or greater.

[(B) Condensation Catalyst]

The condensation catalyst of the component (B) is required for curing the organopolysiloxane of the component (A). Although there are no particular limitations on the condensation catalyst, an organometallic catalyst is normally used as it yields superior stability for the organopolysiloxane, and excellent levels of hardness and resistance to yellowing for the obtained cured product. Examples of this organometallic catalyst include catalysts that contain atoms of metals such as zinc, aluminum, titanium, tin or cobalt, and catalysts that contain zinc, aluminum or titanium atoms are preferred. Examples of preferred organometallic catalysts include organic acid zinc compounds, Lewis acid catalysts, organoaluminum compounds and organotitanium compounds, and specific examples include zinc octoate, zinc benzoate, zinc p-tert-butylbenzoate, zinc laurate, zinc stearate, aluminum chloride, aluminum perchlorate, aluminum phosphate, aluminum triisopropoxide, aluminum acetylacetonate, aluminum butoxy-bis(ethylacetoacetate), tetrabutyl titanate, tetraisopropyl titanate, tin octoate, cobalt naphthenate, and tin naphthenate. Of these, aluminum acetylacetonate and Acetope Al-MX3 (manufactured by Hope Chemicals Co., Ltd.) can be used particularly favorably. These condensation catalysts may be used individually, or in combinations of two or more different catalysts.

The amount added of the condensation catalyst of the component (B) is preferably within a range from 0.05 to 10 parts by mass, and more preferably from 0.1 to 5 parts by mass, per 100 parts by mass of the organopolysiloxane of the component (A). If the amount added is less than 0.05 parts by mass, then the curability may deteriorate, whereas if the amount exceeds 10 parts by mass, the composition tends to be prone to gelling.

[(C) Phosphor]

The phosphor of the component (C) may be any conventional phosphor, and the amount of the phosphor is typically within a range from 0.1 to 1,000 parts by mass, and preferably from 10 to 500 parts by mass, per 100 parts by mass of the component (A). The particle diameter of the phosphor of the component (C), determined in a particle size distribution measurement performed by a laser diffraction method using a Cilas laser measurement apparatus or the like, is typically within a range from 0.01 to 100 μm, preferably from 0.1 to 80 μm, and more preferably from approximately 0.5 to 50 μm. Further, the average particle diameter is preferably from 1 to 50 μm, and more preferably from 3 to 20 μm. Here, the "average particle diameter" refers to the particle diameter at the weight-average value $D_{50}$ (or median value) within a particle size distribution measured using a laser diffraction particle size distribution measurement apparatus.

The phosphor may be any phosphor that absorbs the light emitted from a semiconductor light emitting diode that employs, for example, a nitride-based semiconductor as the light emitting layer, and performs a wavelength conversion that alters the wavelength of the light to a different wavelength. For example, one or more phosphors selected from among nitride-based phosphors or oxynitride-based phosphors activated mainly with lanthanoid elements such as Eu and Ce, alkaline earth halogen apatite phosphors, alkaline earth metal halogen borate phosphors, alkaline earth metal aluminate phosphors, alkaline earth silicate phosphors, alkaline earth sulfide phosphors, alkaline earth thiogallate phosphors, alkaline earth silicon nitride phosphors and germanate phosphors activated mainly with lanthanoid elements such as Eu or transition metal elements such as Mn, rare earth aluminate phosphors and rare earth silicate phosphors activated mainly with lanthanoid elements such as Ce, organic and organic complex phosphors activated mainly with lanthanoid elements such as Eu, and Ca-Al-Si-O-N based oxynitride glass phosphors are preferred. Specific examples of phosphors that can be used include those listed below, but the following is not an exhaustive list. In the description of phosphors presented below, M represents at least one element selected from among Sr, Ca, Ba, Mg and Zn, and X represents at least one element selected from among F, Cl, Br and I. R represents Eu, Mn or a combination of Eu and Mn.

Examples of nitride-based phosphors activated mainly with lanthanoid elements such as Eu and Ce include $M_2Si_5N_8$:Eu and the like. Furthermore, besides $M_2Si_5N_8$:Eu, other examples include $MSi_7N_{10}$:Eu, $M_{1.8}Si_5O_{0.2}N_8$:Eu, and $M_{0.9}Si_7O_{0.1}N_{10}$:Eu.

Examples of oxynitride-based phosphors activated mainly with lanthanoid elements such as Eu and Ce include $MSi_2O_2N_2$:Eu and the like.

Examples of alkaline earth halogen apatite phosphors activated mainly with lanthanoid elements such as Eu or transition metal elements such as Mn include $M_5(PO_4)_3X$:R and the like.

Examples of alkaline earth metal halogen borate phosphors include $M_2B_5O_9X$:R and the like.

Examples of alkaline earth metal aluminate phosphors include $SrAl_2O_4$:R, $Sr_4Al_{14}O_{25}$:R, $CaAl_2O_4$:R, $BaMg_2Al_{16}O_{27}$:R, $BaMg_2Al_{16}O_{12}$:R, and $BaMgAl_{10}O_{17}$:R.

Examples of alkaline earth sulfide phosphors include $La_2O_2S$:Eu, $Y_2O_2S$:Eu, and $Gd_2O_2S$:Eu.

Examples of rare earth aluminate phosphors activated mainly with lanthanoid elements such as Ce include YAG phosphors represented by composition formulas such as $Y_3Al_5O_{12}$:Ce, $(Y_{0.8}Gd_{0.2})_3Al_5O_{12}$:Ce, $Y_3(Al_{0.8}Ga_{0.2})_5O_{12}$:Ce, and $(Y,Gd)_3(Al,Ga)_5O_{12}$. Further, other examples include phosphors such as $Tb_3Al_5O_{12}$:Ce and $Lu_3Al_5O_{12}$:Ce in which some or all of the Y has been replaced with Tb or Lu or the like.

Examples of other phosphors include ZnS:Eu, $Zn_2GeO_4$:Mn and $MGa_2S_4$:Eu and the like.

If desired, the above phosphors may also comprise one or more elements selected from among Tb, Cu, Ag, Au, Cr, Nd, Dy, Co, Ni and Ti, either instead of Eu or in addition to Eu.

Ca-Al-Si-O-N based oxynitride glass phosphors are phosphors in which the matrix material is an oxynitride glass comprising from 20 to 50 mol% of $CaCO_3$ calculated as CaO, from 0 to 30 mol% of $Al_2O_3$, from 25 to 60 mol% of SiO, from 5 to 50% of AlN, and from 0.1 to 20 mol% of rare earth oxides or transition metal oxides, provided that the combination of these five materials totals 100 mol%. In a phosphor that employs an oxynitride glass as the matrix material, the nitrogen content is preferably not more than 15 wt%, and in addition to the rare earth oxide ions, another rare earth element ion that functions as a sensitizer is preferably included within the phosphor glass in the form of a rare earth oxide in a amount within a range from 0.1 to 10 mol% so as to function as a co-activator.

Furthermore, besides the phosphors described above, other phosphors that offer similar performance and effects can also be used.

[Other Optional Components]

In addition to the components (A) to (C) described above, other optional components may also be added to the composition used in the present embodiment, provided the addition of these other components does not impair the actions or effects of the present invention.

- Inorganic filler:

  Adding an inorganic filler can have a number of effects, including ensuring that the light scattering properties of the resulting cured product and the fluidity of the composition fall within appropriate ranges, and reinforcing the materials generated using the composition. Although there are no particular limitations on the inorganic filler, very fine particulate fillers that cause no deterioration in the optical properties are preferred. Examples include reinforcing inorganic fillers such as fumed silica, fumed titanium dioxide and fumed alumina, and non-reinforcing inorganic fillers such as calcium carbonate, calcium silicate, titanium dioxide, ferric oxide, carbon black and zinc oxide. These inorganic fillers may be added to the composition in amounts totaling not more than 600 parts by mass (0 to 600 parts by mass) per 100 parts by mass of the combination of the components (A) and (B).

- Liquid silicone:

  A liquid silicone component may be added to the composition used in the present embodiment as required, provided the silicone composition sheet of the present invention can be maintained in a solid or semisolid state at room temperature, and does not become liquid. This type of liquid silicone component preferably has a viscosity at 25°C of approximately 1 to 100,000 mPa·s, and examples include vinylsiloxanes, hydrogensiloxanes, alkoxysiloxanes, hydroxysiloxanes, and mixtures thereof. The amount added of the liquid silicone component is limited by the condition that the silicone composition sheet must maintain a solid or semisolid state at room temperature, and is typically not more than 50% by mass of the entire silicone composition sheet.

- Other optional components:

  Examples of other optional components which may be added include age resistors, radical inhibitors, ultraviolet absorbers, adhesion improvers, flame retardants, surfactants, storage stability improvers, antiozonants, photostabilizers, thickeners, plasticizers, coupling agents, antioxidants, thermal stabilizers, conductivity improvers, antistatic agents, radiation blockers, nucleating agents, phosphorus-based peroxide decomposition agents, lubricants, pigments, metal deactivators, physical property modifiers, and organic solvents. These optional components may be used either individually, or in combinations of two or more different materials.

The simplest form of the composition used in the present embodiment is a composition comprising the aforementioned components (A) to (C) but containing no inorganic fillers, and in particular, is a composition composed essentially of only the components (A) to (C).

[Preparation of Composition]

The composition of the present invention can be prepared by mixing the components (A) to (C), together with any optional components that are to be added, using any arbitrary mixing method. In a specific example, the organopolysiloxane of the component (A), the catalyst of the component (B), the phosphor of the component (C), and any of the aforementioned optional components are placed in a commercially available mixer (such as a Thinky Conditioning Mixer (manufactured by Thinky Corporation)), and are mixed together uniformly for approximately 1 to 5 minutes to prepare the composition of the present invention.

In order to prevent the curing reaction from proceeding, the organopolysiloxane of the component (A) and the condensation catalyst of the component (B) are usually stored in two separate packs, with these two packs mixed together at the time of use to allow condensation curing to proceed. A single-liquid composition may also be prepared, on the premise of low-temperature storage.

[Composition Sheet]

The composition of the present invention may either be molded into a sheet-like form in a solventless state, or may be dissolved in an organic solvent to form a varnish. The varnish-state composition can be processed into a sheet-like form by heating for several minutes at a temperature of 60 to 180°C using a film coater. Further, the composition may also be processed into a sheet-like form using a hot press apparatus. The molded sheet can be stored, for example, under refrigeration.

There are no particular limitations on the organic solvent used when preparing a varnish, and examples include hydrocarbon-based solvents such as benzene, toluene and xylene, ether-based solvents such as tetrahydrofuran, 1,4-dioxane and diethyl ether, ketone-based solvents such as methyl ethyl ketone, halogenated solvents such as chloroform, methylene chloride and 1,2-dichloroethane, alcohol-based solvents such as methanol, ethanol, isopropyl alcohol and isobutyl alcohol, as well as octamethylcyclotetrasiloxane and hexamethyldisiloxane. Other suitable solvents include cellosolve acetate, cyclohexanone, butyrocellosolve, methyl carbitol, carbitol, butyl carbitol, diethyl carbitol, cyclohexanol, diglyme and triglyme. These organic solvents may be used individually, or in combinations of two or more solvents.

[Sheet Curing]

The composition sheet of the present invention, produced in the manner described above, can be cured immediately by heating when necessary, and is capable of forming a flexible sheet-like cured product having a high degree of hardness and no surface tack.

When curing the composition, curing may be conducted, for example, at 60 to 180°C for approximately 1 to 12 hours, but is preferably conducted by step curing within a range from 60 to 150°C. Step curing is performed, for example, using either two stages, or three or more stages, and is preferably performed using the three stages described below. First, the composition is subjected to low-temperature curing at 25 to 60°C. The curing time is typically within a range from approximately 0.5 to 2 hours. Next, the composition is subjected to heat-curing at 60 to 120°C. The curing time is typically within a range from approximately 0.5 to 2 hours. Finally, the composition is subjected to heat-curing at 150 to 180°C. The curing time is typically within a range from approximately 1 to 10 hours. More specifically, the composition is preferably subjected to low-temperature curing at 60°C for one hour, subsequently subjected to heat-curing at 100°C for 1 to 2 hours, and then subjected to heat-curing at 150°C for 3 to 8 hours. By using a step curing process including these stages, satisfactory curing can be achieved despite the thick coating, foaming does not occur, and a colorless and transparent cured product can be obtained.

The glass transition temperature (Tg) of a cured product obtained by curing the composition of the present invention is usually too high to enable measurement using a commercially available measuring device (such as the thermomechanical tester (product name: TM-7000, measurement range: 25 to 200°C) manufactured by Shinku Riko Co., Ltd.), indicating that the obtained cured product exhibits extremely superior heat resistance.

Crimping is typically performed at a temperature within a range from room temperature to 300°C, under a pressure of not more than 10 MPa (typically 0.01 to 10 MPa), preferably not more than 5 MPa (for example, 0.1 to 5 MPa), and particularly 0.5 to 5 MPa. Curing is typically conducted at 50 to 200°C, and particularly 70 to 180°C, for a period of 1 to 30 minutes, and particularly 2 to 10 minutes. Further, post-curing may be performed at 50 to 200°C, and particularly 70 to 180°C, for a period of 0.1 to 10 hours, and particularly 1 to 4 hours.

<Method of Producing Light Emitting Device>

A method of producing a light emitting device having a covered LED element is provided, the method comprising disposing the adhesive silicone composition sheet described above on the surface of the LED element, and curing the composition sheet by heating, thereby covering the surface of the LED element with a phosphor-containing cured silicone resin layer. Further, a light emitting device having a covered LED element obtained using this production method is also provided.

The composition sheet of the present invention is useful for encapsulating LED elements, and particularly for encapsulating blue LED and ultraviolet LED elements. When producing the LED element, the composition sheet of the present invention is disposed on top of the LED element (typically by crimping), and is subsequently cured by heating, thereby forming a coating of the cured product on top of the LED element. In this manner, a phosphor-containing layer that can perform stable phototransformation can be formed on the surface of the LED element. The thus obtained phosphor-containing layer is a hard material and yet exhibits excellent flexibility, and also has minimal surface tack.

The adhesive silicone composition sheet is typically used with a thickness of 1 to 500 μm, and preferably 10 to 300 μm, but the thickness may be adjusted appropriately in accordance with the phosphor content and the light emission efficiency and the like. The size of the sheet may be matched to the size of the LED element being covered. Following positioning of the sheet on the surface of the LED element, the sheet is subjected to heat-curing. The heat-curing conditions are as described above, and a secondary curing is usually performed after the primary curing.

EXAMPLES

A more detailed description of the present invention is presented below using a series of examples, but the present invention is in no way limited by these examples. The weight-average molecular weight values refer to polystyrene-equivalent values measured by GPC under the conditions mentioned above. Further, the average particle diameter values indicate the particle diameter at the weight-average value $D_{50}$ (or median value) within a particle size distribution measured using a laser diffraction particle size distribution measurement apparatus.

The methyltrimethoxysilane and dimethyldimethoxysilane used in the synthesis examples were manufactured by Shin-Etsu Chemical Co., Ltd.

<Synthesis Example 1>

- Synthesis of organopolysiloxane (A1) -

A 1 L three-neck flask was fitted with a stirrer and a condenser tube. The flask was then charged with 109 g (0.8 mol) of methyltrimethoxysilane, 24 g (0.2 mol) of dimethyldimethoxysilane and 106 g of isobutyl alcohol, and the mixture was cooled in ice with constant stirring. With the temperature inside the system maintained at 0°C to 20°C, 60.5 g of a 0.05 N hydrochloric acid solution was added dropwise. Following completion of the dropwise addition, the resulting reaction mixture was stirred for 11 hours at a reflux temperature of 80°C. Subsequently, the resulting reaction solution was cooled to room temperature, and 150 g of xylene was added to dilute the reaction solution. This diluted reaction solution was then poured into a separating funnel, and washed repeatedly with 300 g samples of water until the electrical conductivity of the separated wash water fell to a value of 2.0 μS/cm or lower. The water was then removed from the washed reaction solution by azeotropic dehydration, and the volatile fraction was adjusted to 30% by mass, thus obtaining 113 g of an organopolysiloxane (a1-1) (which included some organic solvent and had a non-volatile fraction of 70% by mass) with a polystyrene-equivalent weight-average molecular weight of 24,000, represented by formula (5) shown below:

$$(CH_3)_{1.20}(OX)_{0.25}SiO_{1.28} \qquad (5)$$

wherein X represents a combination of hydrogen atoms, methyl groups and isobutyl groups.

Subsequently, the thus obtained 113 g of the organopolysiloxane (a1-1) (which included some organic solvent and had a non-volatile fraction of 70% by mass) and 15.8 g of a polystyrene-based anion exchange resin (Diaion SA10A, moisture content: 43 to 47% by mass) were placed in a flask, and the resulting mixture was reacted by stirring for 72 hours at room temperature. Following completion of this 72 hour reaction, 27 g of xylene was added, and the mixture was then filtered, yielding 135 g of an organopolysiloxane (a1-2) (which included some organic solvent and had a non-volatile fraction of 57% by mass) containing an organopolysiloxane with a weight-average molecular weight maximum value of 210,000, represented by formula (6) shown below:

$$(CH_3)_{1.2}(OX)_{0.12}SiO_{1.34} \qquad (6)$$

wherein X represents a combination of hydrogen atoms, methyl groups and isobutyl groups.

Next, the obtained 135 g of the organopolysiloxane (a1-2) (which included some organic solvent and had a non-volatile fraction of 57% by mass), 36 g of triethylamine and 120 g of xylene were combined in a flask, and with the mixture undergoing constant stirring, 26 g of trimethylsilyl chloride was added dropwise at a temperature of 25°C to 60°C. Following completion of the dropwise addition, the resulting mixture was reacted for a further 2 hours at room temperature, and 200 g of water was then added dropwise to the mixture. Subsequently, the reaction mixture was poured into a separating funnel, and the organic phase was separated and then washed repeatedly with 200 g samples of water until the electrical conductivity of the separated wash water fell to a value of 2.0 μS/cm or lower. The water was then removed from the washed reaction solution by azeotropic dehydration, and the reaction solution was filtered and stripped of solvent, yielding 71 g of an organopolysiloxane (A1) (non-volatile fraction: 92% by mass) with a weight-average molecular weight maximum value of 220,000, represented by formula (7) shown below:

$$(CH_3)_{1.2}(OX)_{0.10}SiO_{1.35} \qquad (7)$$

wherein X represents a combination of $-Si(CH_3)_3$ groups, methyl groups and isobutyl groups.

<Synthesis Example 2>

- Synthesis of organopolysiloxane (A2) -

A I L three-neck flask was fitted with a stirrer and a condenser tube. The flask was then charged with 68.1 g (0.5 mol) of methyltrimethoxysilane, 60.1 g (0.5 mol) of dimethyldimethoxysilane, and 118 g of isobutyl alcohol, and the mixture was cooled in ice with constant stirring. With the temperature inside the system maintained at 0°C to 20°C, 54 g of a 0.05 N hydrochloric acid solution was added dropwise. Following completion of the dropwise addition, the resulting reaction mixture was stirred for 11 hours at a reflux temperature of 80°C. Subsequently, the resulting reaction solution was cooled to room temperature, and 150 g of xylene was added to dilute the reaction solution. This diluted reaction solution was then poured into a separating funnel, and washed repeatedly with 300 g samples of water until the electrical conductivity of the separated wash water fell to a value of 2.0 μS/cm or lower. The water was then removed from the washed reaction solution by azeotropic dehydration, and the volatile fraction was adjusted to 30% by mass, thus obtaining 109 g of an organopolysiloxane (a2-1) (which included some organic solvent and had a non-volatile fraction of 70% by mass) with a weight-average molecular weight of 9,000, represented by formula (8) shown below:

$$(CH_3)_{1.50}(OX)_{0.8}SiO_{1.11} \qquad (8)$$

wherein X represents a combination of hydrogen atoms, methyl groups and isobutyl groups.

Subsequently, the thus obtained 109 g of the organopolysiloxane (a2-1) (which included some organic solvent and had a non-volatile fraction of 70% by mass) and 15.2 g of a polystyrene-based anion exchange resin (Diaion SA10A, moisture content: 43 to 47% by mass) were placed in a flask, and the resulting mixture was reacted by stirring for 72 hours at room temperature. Following completion of this 72 hour reaction, 25 g of xylene was added to the reaction mixture, and the mixture was then filtered, yielding 133 g of an organopolysiloxane (a2-2) (which included some organic solvent and had a non-volatile fraction of 57% by mass) containing an organopolysiloxane with a weight-average molecular weight maximum value of 80,000, represented by formula (9) shown below:

$$(CH_3)_{1.50}(OX)_{0.21}SiO_{1.15} \qquad (9)$$

wherein X represents a combination of hydrogen atoms, methyl groups and isobutyl groups.

Next, the obtained 133 g of the organopolysiloxane (a2-2) (which included some organic solvent and had a non-volatile fraction of 57% by mass), 36 g of triethylamine and 120 g of xylene were combined in a flask, and with the mixture undergoing constant stirring, 26 g of trimethylsilyl chloride was added dropwise at a temperature of 25°C to 60°C. Following completion of the dropwise addition, the resulting mixture was reacted for a further 2 hours at room temperature, and 200 g of water was then added dropwise to the mixture. Subsequently, the reaction mixture was poured into a separating funnel, and the organic phase was separated and then washed repeatedly with 200 g samples of water until the electrical conductivity of the separated wash water fell to a value of 2.0 μS/cm or lower. The water was then removed from the washed reaction solution by azeotropic dehydration, and the reaction solution was filtered and stripped of solvent, yielding 70 g of an organopolysiloxane (A2) (non-volatile fraction: 91 % by mass) with a weight-average molecular weight maximum value of 84,000, represented by formula (10) shown below:

$$(CH_3)_{1.50}(OX)_{0.19}SiO_{1.16} \qquad (10)$$

wherein X represents a combination of $-Si(CH_3)_3$ groups, methyl groups and isobutyl groups.

<Synthesis Example 3>

- Synthesis of organopolysiloxane (A3) -

A I L three-neck flask was fitted with a stirrer and a condenser tube. The flask was then charged with 109 g (0.8 mol) of methyltrimethoxysilane, 14.4 g (0.12 mol) of dimethyldimethoxysilane, 19.5 g (0.08 mol) of diphenyldimethoxysilane and 106 g of isobutyl alcohol, and the mixture was cooled in ice with constant stirring. With the temperature inside the system maintained at 0°C to 20°C, 60.5 g of a 0.05 N hydrochloric acid solution was added dropwise. Following completion of the dropwise addition, the resulting reaction mixture was stirred for 11 hours at a reflux temperature of 80°C. Subsequently, the resulting reaction solution was cooled to room temperature, and 150 g of xylene was added to dilute the reaction solution. This diluted reaction solution was then poured into a separating funnel, and washed repeatedly with 300 g samples of water until the electrical conductivity of the separated wash water fell to a value of 2.0 $\mu$S/cm or lower. The water was then removed from the washed reaction solution by azeotropic dehydration, and the volatile fraction was adjusted to 30% by mass, thus obtaining 120 g of an organopolysiloxane (a3-1) (which included some organic solvent and had a non-volatile fraction of 70% by mass) with a weight-average molecular weight of 25,000, represented by formula (11) shown below:

$$(C_6H_5)_{0.096}(CH_3)_{1.104}(OX)_{0.25}SiO_{1.28} \qquad (11)$$

wherein X represents a combination of hydrogen atoms, methyl groups and isobutyl groups.
Subsequently, the thus obtained 120 g of the organopolysiloxane (a3-1) (which included some organic solvent and had a non-volatile fraction of 70% by mass) and 15.8 g of a polystyrene-based anion exchange resin (Diaion SA10A, moisture content: 43 to 47% by mass) were placed in a flask, and the resulting mixture was reacted by stirring for 72 hours at room temperature. Following completion of this 72 hour reaction, 27 g of xylene was added to the reaction mixture, and the mixture was then filtered, yielding 140 g of an organopolysiloxane (a3-2) (which included some organic solvent and had a non-volatile fraction of 57% by mass) containing an organopolysiloxane with a weight-average molecular weight maximum value of 220,000, represented by formula (12) shown below:

$$(C_6H_5)_{0.096}(CH_3)_{1.104}(OX)_{0.12}SiO_{1.34} \qquad (12)$$

wherein X represents a combination of hydrogen atoms, methyl groups and isobutyl groups.
Next, 140 g of the obtained organopolysiloxane (a3-2) (which included some organic solvent and had a non-volatile fraction of 57% by mass), 36 g of triethylamine and 120 g of xylene were combined in a flask, and with the mixture undergoing constant stirring, 26 g of trimethylsilyl chloride was added dropwise at a temperature of 25°C to 60°C. Following completion of the dropwise addition, the resulting mixture was reacted for a further 2 hours at room temperature, and 200 g of water was then added dropwise to the mixture. Subsequently, the reaction mixture was poured into a separating funnel, and the organic phase was separated and then washed repeatedly with 200 g samples of water until the electrical conductivity of the separated wash water fell to a value of 2.0 $\mu$S/cm or lower. The water was then removed from the washed reaction solution by azeotropic dehydration, and the reaction solution was filtered and stripped of solvent, yielding 75 g of an organopolysiloxane (A3) (non-volatile fraction: 92% by mass) with a weight-average molecular weight maximum value of 230,000, represented by formula (13) shown below:

$$(C_6H_5)_{0.096}(CH_3)_{1.104}(OX)_{0.10}SiO_{1.35} \qquad (13)$$

wherein X represents a combination of $-Si(CH_3)_3$ groups, methyl groups and isobutyl groups.

<Comparative Synthesis Example 1>

- Vinyl group-containing organopolysiloxane resin (Q1) -

An organosilane represented by $PhSiCl_3$: 27 mol, $ClMe_2SiO(Me_2SiO)_{33}SiMe_2Cl$: 1 mol, and $MeViSiCl_2$. 3 mol were dissolved in toluene solvent, the solution was added dropwise to water to effect a cohydrolysis, the product was washed with water, neutralized by alkali washing and dewatered, and the solvent was then stripped, yielding a vinyl group-containing resin (Q 1). In this resin, the composition ratio between the constituent siloxane units and a structure represented by $[-O_{1/2}SiMe_2O-(Me_2SiO)_{33}-SiMe_2O_{1/2}-]$ is represented by the formula:

$[PhSiO_{3/2}]_{0.27}[-O_{1/2}SiMe_2O-(Me_2SiO)_{33}-SiMe_2O_{1/2}-]_{0.01}[MeViSiO_{2/2}]_{0.03}$. The weight-average molecular weight of this resin was 62,000, and the melting point was 60°C.

<Comparative Synthesis Example 2>

- Hydrosilyl group-containing organopolysiloxane resin (Q2) -

An organosilane represented by $PhSiCl_3$ 27 mol, $ClMe_2SiO(Me_2SiO)_{33}SiMe_2Cl$: 1 mol, and $MeHSiCl_2$: 3 mol were dissolved in toluene solvent, the solution was added dropwise to water to effect a cohydrolysis, the product was washed with water, neutralized by alkali washing and dewatered, and the solvent was then stripped, yielding a hydrosilyl group-containing resin (Q2). In this resin, the composition ratio between the constituent siloxane units and a structure represented by $[-O_{1/2}SiMe_2O-(Me_2SiO)_{33}-SiMe_2O_{1/2}-]$ is represented by the formula: $[PhSiO_{3/2}]_{0.27}[-O_{1/2}SiMe_2O-(Me_2SiO)_{33}-SiMe_2O_{1/2}-]_{0.01}[MeHSiO_{2/2}]_{0.03}$- The weight-average molecular weight of this resin was 58,000, and the melting point was 58°C.

<Comparative Synthesis Example 3>

- Synthesis of organopolysiloxane resin (A4) -

A 1 L three-neck flask was fitted with a stirrer and a condenser tube. The flask was then charged with 109 g (0.8 mol) of methyltrimethoxysilane, 9.6 g (0.08 mol) of dimethyldimethoxysilane, 29.3 g (0.12 mol) of diphenyldimethoxysilane and 106 g of isobutyl alcohol, and the mixture was cooled in ice with constant stirring. With the temperature inside the system maintained at 0°C to 20°C, 60.5 g of a 0.05 N hydrochloric acid solution was added dropwise. Following completion of the dropwise addition, the resulting reaction mixture was stirred for 11 hours at a reflux temperature of 80°C. Subsequently, the resulting reaction solution was cooled to room temperature, and 150 g of xylene was added to dilute the reaction solution. This diluted reaction solution was then poured into a separating funnel, and washed repeatedly with 300 g samples of water until the electrical conductivity of the separated wash water fell to a value of 2.0 μS/cm or lower. The water was then removed from the washed reaction solution by azeotropic dehydration, and the volatile fraction was adjusted to 30% by mass, thus obtaining 120 g of an organopolysiloxane (a4-1) (which included some organic solvent and had a non-volatile fraction of 70% by mass) with a weight-average molecular weight of 25,000, represented by formula (14) shown below:

$$(C_6H_5)_{0.144}(CH_3)_{1.056}(OX)_{0.25}SiO_{1.28} \qquad (14)$$

wherein X represents a combination of hydrogen atoms, methyl groups and isobutyl groups.
Subsequently, the thus obtained 120 g of the organopolysiloxane (a4-1) (which included some organic solvent and had a non-volatile fraction of 70% by mass) and 15.8 g of a polystyrene-based anion exchange resin (Diaion SA10A, moisture content: 43 to 47% by mass) were placed in a flask, and the resulting mixture was reacted by stirring for 72 hours at room temperature. Following completion of this 72 hour reaction, 27 g of xylene was added to the reaction mixture, and the mixture was then filtered, yielding 140 g of an organopolysiloxane (a4-2) (which included some organic solvent and had a non-volatile fraction of 57% by mass) containing an organopolysiloxane with a weight-average molecular weight maximum value of 220,000, represented by formula (15) shown below:

$$(C_6H_5)_{0.144}(CH_3)_{1.056}(OX)_{0.12}SiO_{1.34} \qquad (12)$$

wherein X represents a combination of hydrogen atoms, methyl groups and isobutyl groups.
Next, 140g of the obtained organopolysiloxane (a4-2) (which included some organic solvent and had a non-volatile fraction of 57% by mass), 36 g of triethylamine and 120 g of xylene were combined in a flask, and with the mixture undergoing constant stirring, 26 g of trimethylsilyl chloride was added dropwise at a temperature of 25°C to 60°C. Following completion of the dropwise addition, the resulting mixture was reacted for a further 2 hours at room temperature, and 200 g of water was then added dropwise to the mixture. Subsequently, the reaction mixture was poured into a separating funnel, and the organic phase was separated and then washed repeatedly with 200 g samples of water until the electrical conductivity of the separated wash water fell to a value of 2.0 μS/cm or lower. The water was then removed from the washed reaction solution by azeotropic dehydration, and the reaction solution was filtered and stripped of solvent, yielding 75 g of an organopolysiloxane (A4) (non-volatile fraction: 92% by mass) with a weight-average molecular weight maximum value of 230,000, represented by formula (16) shown below:

$$(C_6H_5)_{0.144}(CH_3)_{1.056}(OX)_{0.10}SiO_{1.35} \qquad (16)$$

wherein X represents a combination of -Si($CH_3$)$_3$ groups, methyl groups and isobutyl groups.

[Example 1]

To 100 parts by mass of the silicone resin (A1) synthesized in Synthesis Example 1 were added 0.1 parts by mass of aluminum acetylacetonate as a catalyst, and 30 parts by mass of a phosphor (YAG) having an average particle diameter of 5 μm, and the resulting mixture was stirred thoroughly in a planetary mixer heated at 60°C to prepare a silicone resin composition. This composition was a plastic solid at 25°C. The composition was dissolved in diglyme, the solution was applied to an ETFE film using a film coater, in an amount sufficient to form a coating of 50 μm, and the coating was heated at 100°C for 5 minutes to evaporate the diglyme and dry the composition, thus producing a phosphor-containing composition sheet that existed as a plastic solid at normal temperature.

«Evaluation of Properties»

The following properties were measured and evaluated. The results are shown in Table 1.

1. Mechanical Properties

The composition was subjected to compression molding using a compression molding device, and heat-molding was performed at 150°C for 5 minutes to obtain a cured product. This cured product was then subjected to secondary curing at 150°C for 4 hours, yielding a sheet-like cured product having a thickness of 0.2 mm. This sheet-like cured product was measured for tensile strength (0.2 mm thickness) and hardness (measured using a type D spring tester) in accordance with JIS K 6251 and JIS K 6253.

2. Surface Tack

The surface tack of the cured product obtained upon secondary curing in the same manner as that described above for evaluation of the mechanical properties was ascertained by finger touch. In addition, the cured product was placed in a sample of commercially available silver powder (average particle diameter: 5 μm), and following removal from the powder, the product was blown with air to test whether the silver powder that had adhered to the surface like dust could be removed. When the product exhibited no sensation of tackiness when touched, and all of the silver powder was able to be removed from the product in the silver powder blow test, the tack was evaluated as "No", whereas when the product exhibited a sensation of tackiness when touched, and/or at least a portion of the silver powder remained adhered to the product, the tack was evaluated as "Yes".

3. Dispersion Stability of Phosphor

A concave depression with a diameter of 6 mm and a central depth of 2 mm formed in an alumina substrate was filled with the above resin composition immediately following preparation, and heat-curing was then conducted in the same manner as that described above in the evaluation of the mechanical properties, thereby molding a circular plate-shaped molded item having a thickness of 2 mm and a diameter of 6 mm. Samples were cut from an upper surface layer (thickness: 0.2 mm) and a lower surface layer (thickness: 0.2 mm) of the molded item, each sample was ashed by heating at 800°C, the amount (% by mass) of phosphor within the obtained ash was measured, and the phosphor content within the upper portion and lower portion was measured, and the difference in the phosphor content between the upper portion and the lower portion was recorded as the measurement value.

Moreover, another sample of the composition was stored in a freezer at -20°C for 3 months, the composition was then molded in the same manner as described above, the phosphor content within the upper portion and lower portion was measured in the same manner as above, and the difference in the phosphor content between the upper portion and the lower portion was recorded as the measurement value.

The measurement value immediately following preparation, and the measurement value following storage were compared, and when the change in the measurement value upon storage was 5% or greater, the phosphor was deemed to have "separated". The dispersion stability of the phosphor was measured in this manner.

4. UV Irradiation Resistance Test

The obtained composition was placed on a glass substrate and crimped using a laminator, and step curing was then performed by heating at 60°C for 1 hour, heating at 100°C for 1 hour, and then heating at 150°C for 4 hours,

thus forming a cured product on the glass substrate. This cured product was then irradiated with UV light (30 mW) for 24 hours using a UV irradiation device (product name: Eye Ultraviolet Curing Apparatus, manufactured by Eyegraphics Co., Ltd.). The surface of the cured product following UV irradiation was then inspected visually. If absolutely no deterioration of the cured product surface was noticeable, an evaluation of "good" was recorded as "A", if slight deterioration was noticeable, an evaluation of "slight deterioration" was recorded as "B", and if significant deterioration was noticeable, an evaluation of "deterioration" was recorded as "C".

5. Brightness Measurement

The composition was sandwiched between two ETFE films, and compression molding was performed at 80°C under a pressure of 5 t for 5 minutes using a hot press apparatus, thus obtaining a composition sheet that had been molded into a sheet-like form having a thickness of 50 μm. The obtained composition sheet was cut into small chip-size pieces with the ETFE films still attached. As illustrated in FIG. 1, the ETFE film was peeled off one surface of a thus obtained sheet piece, the sheet piece was positioned on a GaN-based LED chip 1 so that the exposed composition made contact with the LED chip 1, and the other ETFE film was then removed. Next, heat-molding was performed at 150°C for 5 minutes, thereby forming a cured phosphor-containing resin layer 2 on the LED chip. Secondary curing was then performed by heating at 150°C for 60 minutes. Using the thus obtained LED chip 1 covered with the phosphor-containing silicone resin layer 2, a light emitting semiconductor (LED) device having the type of flip-chip structure illustrated in FIG. 1 was formed on top of a ceramic circuit board 3. In the figure, numeral 4 indicates solder balls. A current of 100 mA was passed through the thus obtained LED device to light the LED, and the initial brightness and the brightness after 500 hours, and after 1,000 hours was measured using an LED optical properties monitor (LE-3400) manufactured by Otsuka Electronics Co., Ltd. These measurements were performed for three LED devices, and the average values were calculated.

[Example 2]

To 100 parts by mass of the silicone resin (A2) synthesized in Synthesis Example 2 were added 0.1 parts by mass of aluminum acetylacetonate as a catalyst, and 30 parts by mass of a phosphor (YAG) having an average particle diameter of 5 μm, and the resulting mixture was stirred thoroughly in a planetary mixer heated at 60°C to prepare a silicone resin composition. This composition was a plastic solid at 25°C. The composition was dissolved in diglyme, the solution was applied to an ETFE film using a film coater, in an amount sufficient to form a coating of 50 μm, and the coating was dried at 100°C for 5 minutes, thus producing a phosphor-containing composition sheet that existed as a plastic solid at normal temperature.

[Example 3]

To 100 parts by mass of the silicone resin (A3) synthesized in Synthesis Example 3 were added 0.1 parts by mass of aluminum acetylacetonate as a catalyst, and 30 parts by mass of a phosphor (YAG) having an average particle diameter of 5 μm, and the resulting mixture was stirred thoroughly in a planetary mixer heated at 60°C to prepare a silicone resin composition. This composition was a plastic solid at 25°C. The composition was dissolved in diglyme, the solution was applied to an ETFE film using a film coater, in an amount sufficient to form a coating of 50 μm, and the coating was dried at 100°C for 5 minutes, thus producing a phosphor-containing composition sheet that existed as a plastic solid at normal temperature.

[Comparative Example 1]

To 70 parts by mass of a commercially available addition reaction-curable silicone varnish KJR-632 (product name, manufactured by Shin-Etsu Chemical Co., Ltd.) containing a vinyl group-containing organopolysiloxane resin that was liquid at normal temperature as the main component, which was used instead of the resin of Example 1, was added 30 parts by mass of the same phosphor (YAG) having an average particle diameter of 5 μm used in Example 1. The resulting mixture was stirred thoroughly in a planetary mixer heated at 60°C to prepare a composition, a sheet was produced from the composition, and the properties of the sheet were evaluated in the same manner as that described for Example 1. The results are shown in Table 1.

[Comparative Example 2]

To 70 parts by mass of a addition reaction silicone varnish (KJR-632 ; manufactured by Shin-Etsu Chemical Co., Ltd.) containing, as the main component, a phenyl-vinyl group-containing organopolysiloxane resin that was solid

at normal temperature and was prepared from 34.9 parts by mass of each of the resins prepared in Comparative Synthesis Examples 1 and 2, 0.1 parts by mass of a platinum catalyst and 0.1 parts by mass of a reaction retarder (Ethynyl 50, manufactured by Nissin Chemical Co., Ltd.), which was used instead of the silicone resin composition prepared in Example 1, was added 30 parts by mass of the same phosphor (YAG) having an average particle diameter of 5 μm used in Example 1. The resulting mixture was stirred thoroughly in a planetary mixer heated at 60°C to prepare a composition, a sheet was produced from the composition, and the properties of the sheet were evaluated in the same manner as that described for Example 1. The results are shown in Table 1.

[Comparative Example 3]

To 100 parts by mass of the silicone resin (A4) synthesized in Comparative Synthesis Example 3 were added 0.1 parts by mass of aluminum acetylacetonate as a catalyst, and 30 parts by mass of a phosphor (YAG) having an average particle diameter of 5 μm, and the resulting mixture was stirred thoroughly in a planetary mixer heated at 60°C to prepare a silicone resin composition. This composition was a plastic solid at 25°C. The composition was dissolved in diglyme, the solution was applied to an ETFE film using a film coater, in an amount sufficient to form a coating of 50 μm, and the coating was dried at 100°C for 5 minutes, thus producing a phosphor-containing composition sheet that existed as a plastic solid at normal temperature.

[Table 1]

| | Example 1 | Example 2 | Example 3 | Comparative Example 1 | Comparative Example 2 | Comparative Example 3 |
|---|---|---|---|---|---|---|
| Methyl substituent content * | 100% | 100% | 92% | 50% | 60% | 88% |
| Side surface thickness (μm) | 50 | 50 | 50 | 50 | 50 | 50 |
| Hardness (D) | 50 | 50 | 50 | 70 | 40 | 50 |
| Tensile strength (MPa) | 5 | 5 | 5 | - | 3 | 5 |
| Tack | No | No | No | No | No | No |
| Dispersion stability of phosphor | No change | No change | No change | Separated | No change | No change |
| UV irradiation test | A | A | A | C | B | B |
| Initial brightness (lm·w) | 80 | 80 | 80 | 74 | 76 | 78 |
| 500 hours (lm·w) | 80 | 79 | 79 | 70 | 74 | 76 |
| 1, 000 hours (lm·w) | 80 | 79 | 79 | 61 | 73 | 75 |

$$* \text{ Methyl substituent content } (\%) = N/M \times 100$$

N: number of moles of methyl groups substituted on silicon atoms
M: number of moles of all organic groups substituted on silicon atoms

DESCRIPTION OF THE REFERENCE SIGNS

1 LED chip
2 Phosphor-containing silicone resin layer
3 Ceramic circuit board
4 Solder ball

## Claims

1. An adhesive silicone composition sheet, formed from a heat-curable silicone resin composition, which comprises:

   (1) an organopolysiloxane in which at least 90% of organic groups bonded to silicon atoms are methyl groups,
   (2) a curing agent, and
   (3) a phosphor,
   and which exists in a plastic solid or semisolid state at normal temperature.

2. The composition sheet according to Claim 1, wherein the organopolysiloxane of component (1) is an organopolysiloxane having a polystyrene-equivalent weight-average molecular weight maximum value of at least $1\times10^4$, represented by an average composition formula (1) shown below:

$$R^1_a(OX)_bSiO_{(4-a-b)/2} \qquad (1)$$

   wherein each $R^1$ independently represents an alkyl group, alkenyl group or aryl group of 1 to 6 carbon atoms, each X independently represents $-Si(R^2R^3R^4)$ (wherein each of $R^2$, $R^3$ and $R^4$ represents an alkyl group, alkenyl group, aryl group, or halogen-substituted group thereof, provided that at least 90% of a combination of all $R^1$, $R^2$, $R^3$ and $R^4$ groups within the formula are methyl groups), or an alkyl group, alkenyl group, alkoxyalkyl group or acyl group of 1 to 6 carbon atoms, a represents a number from 1.00 to 1.50 and b represents a number that satisfies $0<b<2$, provided that a+b satisfies $1.00<a+b<2.00$, and
   the curing agent of component (2) is a condensation catalyst.

3. The composition sheet according to Claim 2, wherein $R^2$, $R^3$ and $R^4$ are methyl groups.

4. The composition sheet according to Claim 2, wherein $R^1$ is an alkyl group of 1 to 6 carbon atoms.

5. The composition sheet according to any one of Claims 2 to 4, wherein $R^1$ is a methyl group.

6. The composition sheet according to any one of Claims 2 to 5, wherein the condensation catalyst of component (2) is an organometallic catalyst.

7. The composition sheet according to Claim 6, wherein the organometallic catalyst comprises at least one type of atom selected from the group consisting of tin, zinc, aluminum and titanium.

8. The adhesive silicone composition sheet according to Claim 6, wherein the organometallic catalyst is an aluminum chelate compound.

9. The composition sheet according to Claim 8, wherein the organometallic catalyst is an acetylacetone-modified aluminum compound.

10. The composition sheet according to any one of Claims 1 to 9, wherein the composition further comprises an organic solvent, and the composition sheet is obtained by applying the composition to a substrate to form a coating, and then drying the coating by heating.

**11.** The adhesive silicone composition sheet according to any one of Claims 1 to 10, comprising 0.05 to 10 parts by mass of the curing agent of component (2) and 0.1 to 1,000 parts by mass of the phosphor of component (3) per 100 parts by mass of the organopolysiloxane of component (1).

**12.** The adhesive silicone composition sheet according to any one of Claims 1 to 11, wherein an average particle diameter of the phosphor of component (3) is from 1 to 50 $\mu$m.

**13.** A method of producing a light emitting device having a covered LED element, the method comprising: disposing the adhesive silicone composition sheet according to any one of Claims 1 to 12 on a surface of the LED element, and curing the composition sheet by heating, thereby covering the surface of the LED element with a phosphor-containing cured silicone resin layer.

**14.** A light emitting device having a covered LED element, which is obtained using the method according to Claim 13.

Fig. 1

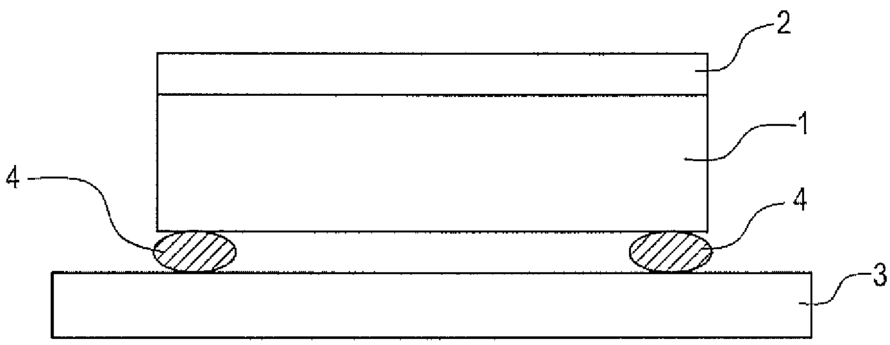

Europäisches Patentamt
European Patent Office
Office européen des brevets

# EUROPÄISCHER RECHERCHENBERICHT

Nummer der Anmeldung
EP 13 15 1595

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 876 201 A1 (SHINETSU CHEMICAL CO [JP]) 9. Januar 2008 (2008-01-09)<br>* Absätze [0007], [0010], [0024], [0027], [0035], [0036], [0043] - [0045], [0047] - [0051] *<br>* Beispiel 1 *<br>----- | 1-14 | INV.<br>C09J183/06 |
| X | EP 1 780 235 A2 (SHINETSU CHEMICAL CO [JP]) 2. Mai 2007 (2007-05-02)<br>* Absätze [0006], [0007], [0021], [0039] - [0040], [0042], [0043], [0047], [0055] *<br>* Beispiel 1 *<br>----- | 1-10, 12-14 | |
| X | EP 1 780 242 A2 (SHINETSU CHEMICAL CO [JP]) 2. Mai 2007 (2007-05-02)<br>* Absätze [0004], [0005], [0013] - [0015], [0019], [0026], [0033], [0045], [0047], [0049], [0050] *<br>* Beispiel 1 *<br>----- | 1-10, 12-14 | |
| | | | RECHERCHIERTE SACHGEBIETE (IPC) |
| | | | C09J<br>C08G<br>C09D<br>C08L |

Der vorliegende Recherchenbericht wurde für alle Patentansprüche erstellt

1

| Recherchenort | Abschlußdatum der Recherche | Prüfer |
|---|---|---|
| Den Haag | 29. April 2013 | Queste, Sébastien |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 13 15 1595

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-04-2013

| Im Recherchenbericht angeführtes Patentdokument | Datum der Veröffentlichung | Mitglied(er) der Patentfamilie | Datum der Veröffentlichung |
|---|---|---|---|
| EP 1876201 A1 | 09-01-2008 | EP 1876201 A1 | 09-01-2008 |
| | | JP 2008013623 A | 24-01-2008 |
| | | KR 20080004372 A | 09-01-2008 |
| | | TW 200823264 A | 01-06-2008 |
| | | US 2008008867 A1 | 10-01-2008 |
| EP 1780235 A2 | 02-05-2007 | CN 1955209 A | 02-05-2007 |
| | | EP 1780235 A2 | 02-05-2007 |
| | | JP 4781779 B2 | 28-09-2011 |
| | | JP 2007119568 A | 17-05-2007 |
| | | KR 20070045967 A | 02-05-2007 |
| | | US 2007099008 A1 | 03-05-2007 |
| EP 1780242 A2 | 02-05-2007 | CN 1970675 A | 30-05-2007 |
| | | EP 1780242 A2 | 02-05-2007 |
| | | JP 4781780 B2 | 28-09-2011 |
| | | JP 2007119569 A | 17-05-2007 |
| | | KR 20070045947 A | 02-05-2007 |
| | | US 2007099009 A1 | 03-05-2007 |

EPO FORM P0461

Für nähere Einzelheiten zu diesem Anhang : siehe Amtsblatt des Europäischen Patentamts, Nr.12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005524737 A
- JP 2004339482 A